# EUROPEAN PATENT APPLICATION

(11) **EP 4 276 056 A1**
(43) Date of publication of application: **15.11.2023**
(21) Application number: 23170279.6
(22) Date of filing: 27.04.2023
(51) Int. Cl.: B81B 7/00

(54) **MICROELECTROMECHANICAL DEVICE AND PROCESS FOR MANUFACTURING A MICROELECTROMECHANICAL DEVICE**

(30) Priority: 09.05.2022 IT 202200009488
(71) Applicant: STMicroelectronics S.r.l., 20864 Agrate Brianza (MB) (IT)
(72) Inventor: DANIELE, Filippo, 20149 MILANO (IT); BALDO, Lorenzo, 20010 BAREGGIO (MI) (IT); MAERNA, Davide, 20864 AGRATE BRIANZA (MB) (IT); DUQI, Enri, 20147 MILANO (IT)
(74) Representative: Studio Torta S.p.A.

(57) **Abstract**

A microelectromechanical device includes a support structure (3, 5), a microelectromechanical system die (7), incorporating a microstructure (12) and a connection structure (13) between the microelectromechanical system die (7) and the support structure (3, 5). The connection structure (13) includes a spacer structure (15), joined to the support structure (3, 5), and a film (16) applied to one face of the spacer structure (15) opposite to the support structure (3, 5). The spacer structure (15) laterally delimits at least in part a cavity (18) and the film (16) extends on the cavity (18), at a distance from the support structure (3, 5). The microelectromechanical system die (7) is joined to the film (16) on the cavity (18).

## Description

The present invention relates to a microelectromechanical device and to a process for manufacturing a microelectromechanical device.

As is known, some microelectromechanical devices are particularly sensitive to stresses which may cause deformations even minor ones. For example, different membrane sensors and transducers, such as pressure sensors and electroacoustic transducers, are affected by the mechanical stresses conveyed by the package wherein they are accommodated. The stresses may have various origins. Among the most frequent, the thermomechanical stresses resulting from exposure to strong temperature variations or from the presence of materials with different thermal expansion coefficients and the stresses from residual internal strains after manufacturing may be mentioned. As mentioned, mechanical stresses of this kind cause temporary or permanent deformations that affect critical elements of the sensors, for example membranes or piezoelectric transduction structures, and may alter the performances. In some cases, the error due to the stresses from the package may not be compatible with the required resolution and accuracy.

In order to overcome the problems caused by the mechanical stresses conveyed by the package, it has been proposed to interpose soft glue layers between the die containing the microelectromechanical structure of the device and the support structure of this die (generally a polymeric substrate or a printed circuit board; or an additional die, possibly mounted on a polymeric substrate or a printed circuit board). In this manner, a certain degree of decoupling is obtained.

However, the solution may not be entirely satisfactory. In fact, a considerable thickness of the soft glue layer may be required to obtain the desired degree of decoupling. Yet, providing a soft glue layer of sufficient thickness may be difficult. Furthermore, during the steps of placing the microelectromechanical devices, the soft glue layer, beyond a certain thickness, does not offer a sufficiently stiff support and may make bonding difficult, reducing the yield of the manufacturing processes. Conversely, a reduced thickness may not achieve a suitable degree of mechanical decoupling and therefore may not represent an acceptable solution.

The aim of the present invention is to provide a microelectromechanical device and a process for manufacturing a microelectromechanical device which allow the limitations described to be overcome or at least mitigated.

According to the present invention a microelectromechanical device and a process for manufacturing a microelectromechanical device are provided as defined in claims 1 and 16, respectively.

For a better understanding of the invention, some embodiments thereof will now be described, purely by way of non-limiting example and with reference to the attached drawings, wherein:
- Figure 1 is a top plan view of a microelectromechanical device according to an embodiment of the present invention;
- Figure 2 is a cross-section through the microelectromechanical device of Figure 1, taken along line II-II of Figure 1;
- Figure 3 is a cross-section through the microelectromechanical device of Figure 1, taken along line III-III of Figure 1;
- Figure 4 is a cross-section through a microelectromechanical device according to a different embodiment of the present invention;
- Figure 5 is a top plan view of a microelectromechanical device according to another embodiment of the present invention;
- Figure 6 is a cross-section through the microelectromechanical device of Figure 5, taken along line VI-VI of Figure 5;
- Figure 7 is a cross-section through a microelectromechanical device according to a further embodiment of the present invention;
- Figure 8 is a cross-section through a microelectromechanical device according to a different embodiment of the present invention;
- Figures 9-11 illustrate successive steps of a process for manufacturing a microelectromechanical device according to an embodiment of the present invention; and
- Figure 12 is a simplified block diagram of an electronic system incorporating a microelectromechanical device according to the present invention.

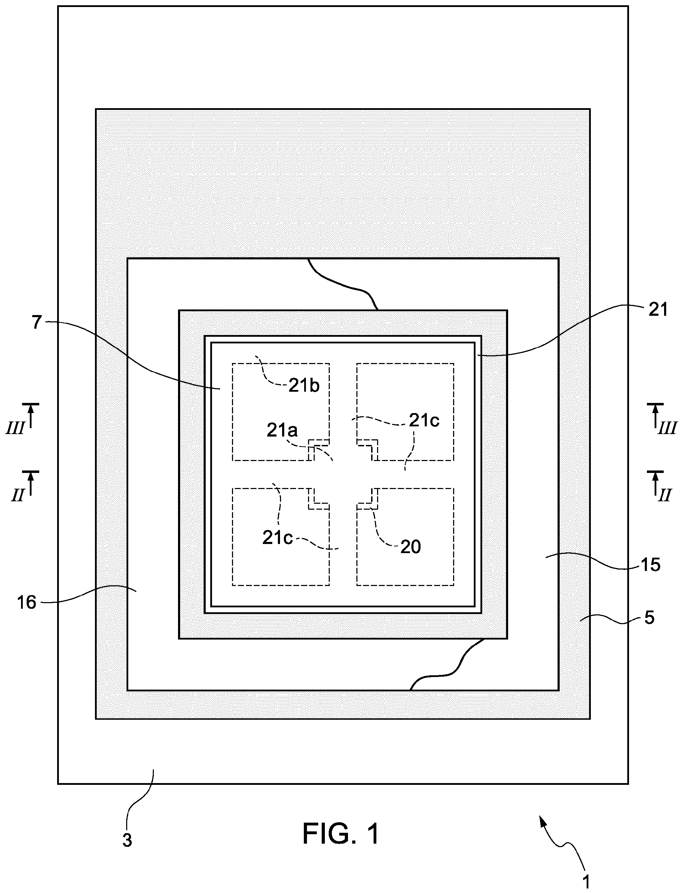

With reference to Figures 1-3, a microelectromechanical device or MEMS (Micro-Electro-Mechanical System) is indicated as a whole with the number 1 and comprises a package, whereof only a substrate 3, a control die 5 and a microelectromechanical system die or, as will be indicated below for simplicity, MEMS die 7 are shown for simplicity.

The substrate 3 has a support function and may be, for example, a polymeric material layer or a printed circuit board (PCB).

The control die 5 is joined to the substrate 3 by an adhesive layer 8 and incorporates a dedicated control circuit or ASIC (Application Specific Integrated Circuit) 9, not illustrated herein in detail. The control die 5, in particular the dedicated control circuit 9, is functionally coupled to the MEMS die 7 to perform the operations wherefor the MEMS die 7 is designed (in general, the conversion of sensed physical quantities into electrical signals and/or the conversion of electrical signals into physical quantities). The connection between the dedicated control circuit 9 and the MEMS die 7, may be obtained by wire bonding and is not illustrated herein for simplicity.

The MEMS die 7 incorporates a microelectromechanical structure 12, for example a membrane, and for example operates as a piezoelectric, piezoresistive or capacitive pressure sensor. However, the invention should not be construed as limited to these examples, but may be generally exploited when desired for any type of microelectromechanical device, including, in particular, electroacoustic transducers (microphones and speakers).

The MEMS die 7 is joined to a support structure which, in the embodiment of Figures 1-3, is defined by the substrate 3 and the control die 5. In particular, the MEMS die 7 is joined to a face of the control die 5 opposite to the substrate 3. In other embodiments, not shown, the MEMS die might be joined directly to the substrate 3 or to a different intermediate substrate or yet the support structure may be defined by the sole control die 5.

In order to join the MEMS die 7 to the support structure, the microelectromechanical device 1 comprises a connection structure 13. In turn, the connection structure 13 comprises a spacer structure 15, formed on the control die 5, and a film 16 applied to one face of the spacer structure 15 opposite to the control die 5.

The spacer structure 15 is formed for example by a resist layer deposited on the control die 5 and subsequently patterned. In the embodiment of Figures 1-3, the spacer structure 15 comprises a first portion, forming an outer frame 17 which laterally delimits a cavity 18, and a second portion, which defines an anchor 20 inside the cavity 18. The cavity 18 is further delimited by the face of the control die 5 on which the spacer structure 15 is formed. In plan, the frame 17 and the anchor 20 may have a polygonal shape, for example square or rectangular. The frame 17 may not be continuous in some embodiments. In these cases, the cavity 18 is laterally delimited only in part and may communicate with the outside. The cavity 18 has greater dimensions (width and length) with respect to corresponding dimensions of the MEMS die 7.

The film 16 in one embodiment is obtained from a dry resist sheet laminated on the spacer structure 15 and subsequently patterned. In particular, the film 16 forms a platform 21 bonded to the anchor 20 and maintained by the same anchor 20 at least partially suspended on the cavity 18 at a distance from the control die 5. An outer portion 22 of the film 16 may be present on the frame 17 of the spacer structure 15.

In the embodiment of Figures 1-3, the platform 21 is centrally supported by the anchor 20. In detail, the platform 21 comprises a central anchor portion 21a supported by the anchor 20, an outer frame 21b and arms 21c projecting from the anchor 20 and connecting the central anchor portion 21b to the outer frame 21a. The outer frame 21a in one embodiment is quadrangular and defines an outer shape of the platform 21. The anchor 20, also quadrangular, has dimensions not greater than 300 of corresponding dimensions of the platform 21. In practice, each side of the anchor 20 is not greater than 30% of a corresponding side of the outer frame 21b of the platform 21. The arms 21c have a width comprised between 5% and 15% of a maximum dimension of the platform 21, for example 10%.

The MEMS die 7 is joined to the platform 21, more precisely to the outer frame 21b. Like the platform 21, the MEMS die 7 is also centrally supported by the sole anchor 20 and projects laterally, remaining suspended on the cavity 18. Since the dimensions (width and length) of the cavity 18 are greater than the corresponding dimensions of the MEMS die 7, the MEMS die may be arranged so that it is not superimposed on the frame 17 of the spacer structure 15.

In the embodiment described, the mechanical connection between the MEMS die 7 and the support structure, in this case formed by the substrate 3 and the control die 5, is limited to the anchor 20. Since the dimensions of the anchor 20 are small and significantly smaller with respect to the dimensions of the MEMS die 7, the deformations and stresses whereto the support structure is subject are not conveyed, or at least are conveyed to a negligible extent, to the MEMS die 7. Consequently, the operation of the MEMS die 7 is not affected by the effects of the deformations and the stresses induced by outer factors, for example of thermomechanical origin, to the advantage of the accuracy.

The dimensions of the platform 21 may be conveniently chosen so that the placing of the MEMS die 7 may be carried out accurately and without difficulty.

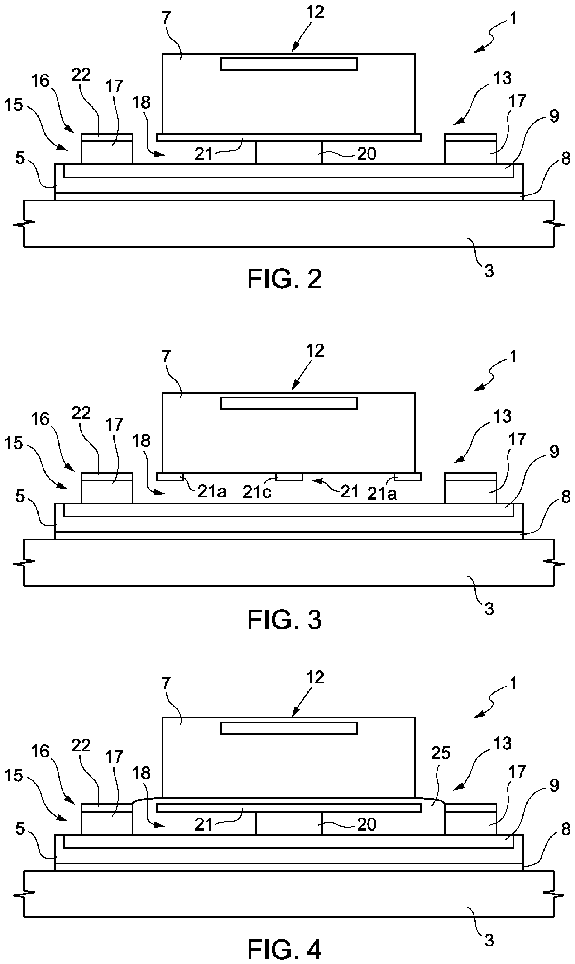

In one embodiment (Figure 4), the cavity 18 is filled with a sealing gel 25, for example potting gel. The sealing gel 25 makes the cavity 18 impermeable and protects the dedicated control circuit 9 from humidity. The sealing gel may cover the platform 21. In this case, a thin gel layer may be interposed between the platform 21 and the MEMS die 7.

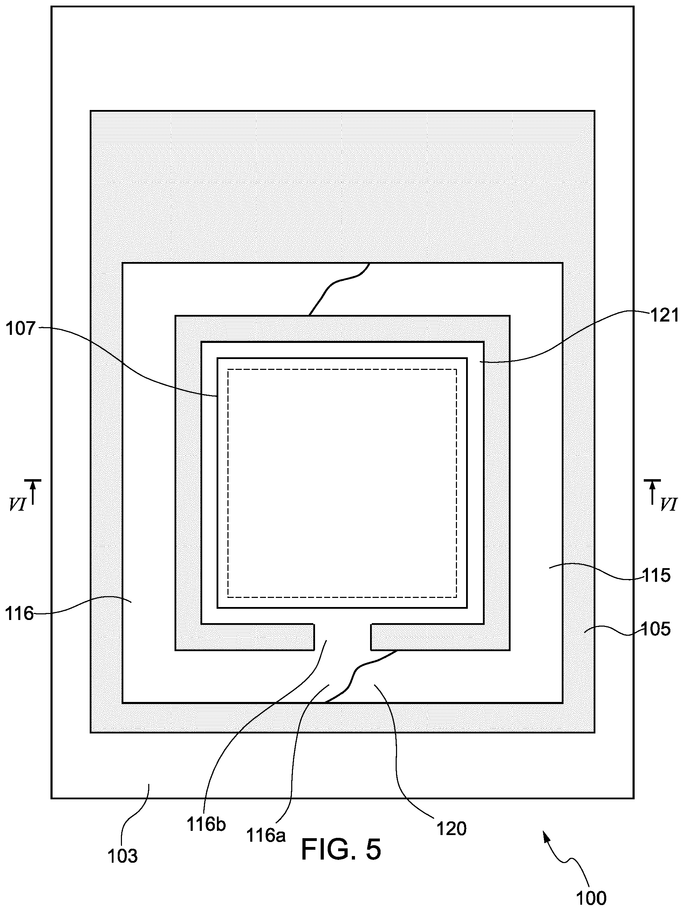

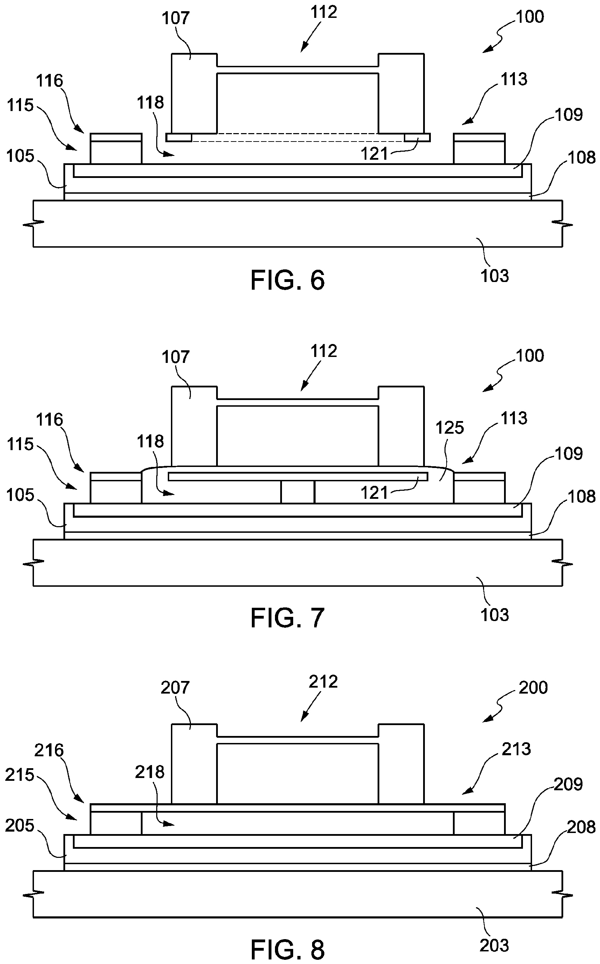

According to an embodiment of the invention, illustrated in Figures 5 and 6, a microelectromechanical device 100 comprises a package, whereof only a substrate 103, a control die 105 and a MEMS die 107 are shown for simplicity. The substrate 103 and the control die 5 are joined to each other, for example by an adhesive layer 108, and form a support structure for the MEMS die 107, substantially as already described.

The MEMS die 107 incorporates a microelectromechanical structure 112, here again of the membrane type, and for example operates as an electroacoustic transducer (microphone or loudspeaker).

The microelectromechanical device 100 comprises a connection structure 113 which joins the MEMS die 107 to the support structure, in particular to the control die 105. In turn, the connection structure 113 comprises a spacer structure 115, formed on the control die 105, and a film 116 applied to one face of the spacer structure 115 opposite to the control die 105. The spacer structure 115 forming a frame which laterally delimits a cavity 118, having greater dimensions (width and length) with respect to corresponding dimensions of the MEMS die 107.

The film 116 is obtained from a dry resist sheet laminated on the spacer structure 115 and subsequently patterned. In particular, the film 116 forms a platform 121 bonded to an anchor 120, defined by a portion, for example one side, of the spacer structure 115. The platform 121 is supported laterally by the anchor 120 and maintained by the same anchor 120 at least partially suspended on the cavity 118 at a distance from the control die 105. More precisely, the film 116 comprises an anchor portion 116a supported by the anchor 120 and an arm 116b which connects the anchor portion 116a to an outer side of the platform 121, which is frame-shaped and has a central opening.

The MEMS die 107 is joined to the platform 121 and is therefore supported laterally with respect to the anchor 120, above the cavity 118. The support for the MEMS die 107 in this case is provided exclusively by the platform 121 and the arm 116b which connects the platform 121 to the anchor portion 116 of the film 116. The width and length of the arm 116b, in particular, may be selected so that the same arm 116b has sufficient stiffness to support the MEMS die 107.

In this case, the MEMS die 107 is completely insensitive to the deformations of the support structure and the functioning is not affected, in particular, by the thermomechanical stresses and residual stresses that might be conveyed through the support structure. The platform 121, in fact, is connected to the anchor 120 only through the arm 116b and the MEMS die 107 does not overlap at any point on the spacer structure 115. The deformations of the support structure may at most slightly modify the relative position of the platform 121 and the MEMS die 107 with respect to the same support structure, but the strains are not conveyed.

Also in this case, the cavity 118 may be filled with a sealing gel 125, as shown in the embodiment of Figure 7.

With reference to Figure 8, in one embodiment of the present invention a microelectromechanical device 200 may comprise a package with a substrate 203, a control die 205, a MEMS die 207, incorporating a microelectromechanical structure 212, and a connection structure 213 which joins the MEMS die 207 to the support structure formed by the substrate 203 and the control die 205 joined to each other. The connection structure 213 comprises a frame-shaped spacer structure 215, formed on the control die 205 and delimiting a cavity 218, and a film 216 applied to one face of the spacer structure 215 opposite to the control die 205. The film 216 in this case is continuous and closes the cavity 218, which has a length and width greater than the length and width of the MEMS die 207.

The MEMS die 207 is joined to the film 216 above the cavity 218 and is therefore suspended without overlapping the spacer structure 215.

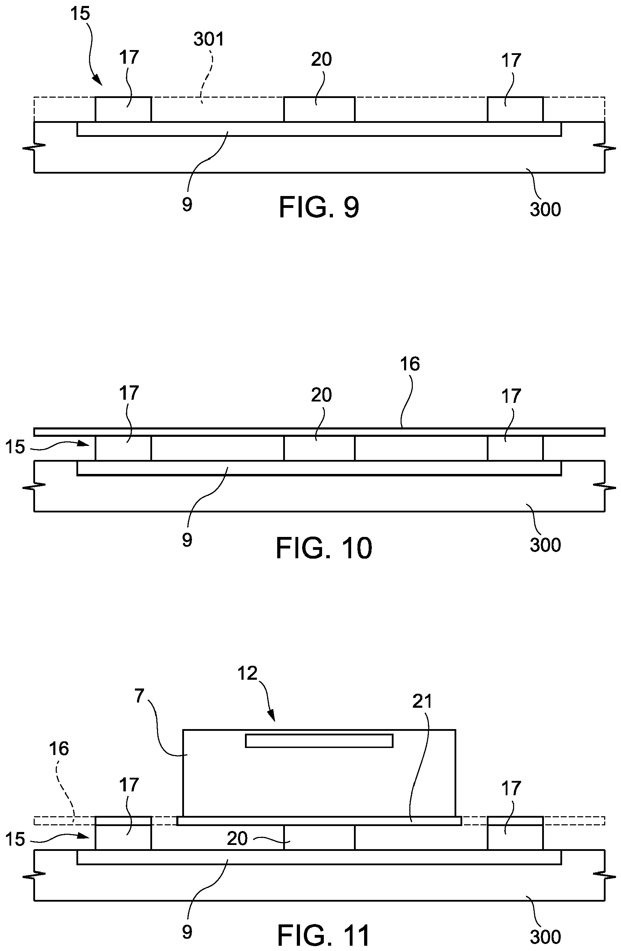

Figures 9-11 summarily show an example of a process for manufacturing a microelectromechanical device according to the invention, in particular the microelectromechanical device of Figures 1-3.

In a semiconductor wafer 300 the dedicated control circuit 9 is initially provided, then a spacer layer 301 of resist is deposited and patterned by a first photolithographic process to form the spacer structure 15, including the anchor 20.

The film 16 (Figure 10) of dry resist is laminated on the wafer 300 and adheres to the spacer structure 15 which projects.

The film 16 is defined with a second photolithographic process to form the platform 21 (Figure 11) and the MEMS die 7, provided separately from a different semiconductor wafer not shown, is joined to the platform 21. The wafer 300 is then diced and the composed dice obtained are joined to respective substrates 3, to form the microelectromechanical device 1 of Figures 1-3.

Alternatively, before joining the MEMS die 7, the cavity is filled with the sealing gel 25, to obtain the structure of Figure 4.

The structures of Figures 5-6 and Figure 7 may be provided with the same process, simply by using photolithographic masks with the desired pattern.

In order to provide the microelectromechanical device 200 of Figure 8, the MEMS die 207 is joined to the film 216 without having carried out the second photolithographic process.

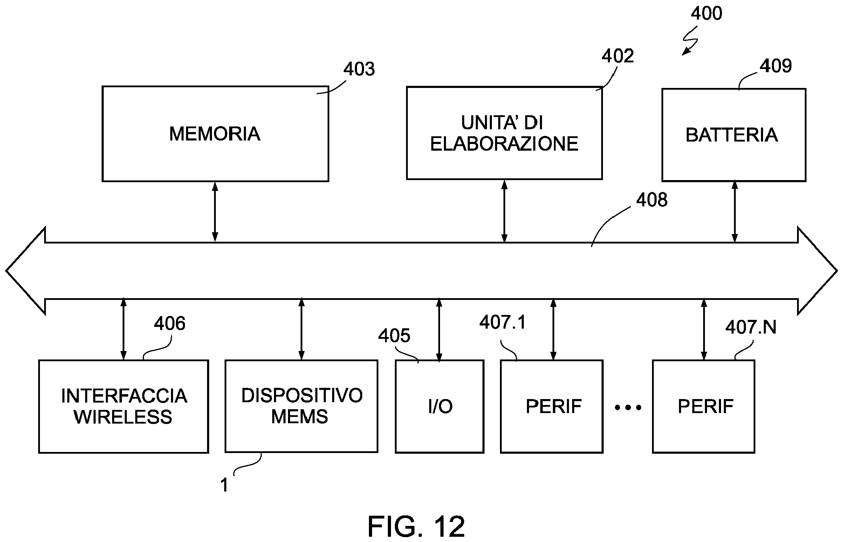

Figure 12 shows an electronic system 400 which may be of any type, in particular, but not limited to, a wearable device, such as a watch, a bracelet or a "smart" band; a computer, such as a mainframe, a personal computer, a laptop, or a tablet; a smartphone; a digital music player, a digital camera or any other device for processing, storing, transmitting or receiving information. The electronic system 400 may be a general purpose or device-embedded processing system, an equipment or a further system.

The electronic system 400 comprises a processing unit 402, memory devices 403, a microelectromechanical device according to the invention, for example the microelectromechanical device (pressure sensor) 1 of Figure 1, and may also be provided with input/output (I/O) devices 405 (for example a keyboard, a pointer or a touch screen), a wireless interface 406, peripherals 407.1, ..., 407.N and possibly further auxiliary devices, not shown here. The components of the electronic system 400 may be coupled in communication with each other directly and/or indirectly through a bus 408. The electronic system 400 may further comprise a battery 409. It should be noted that the scope of the present invention is not limited to embodiments necessarily having one or all of the listed devices.

The processing unit 402 may comprise, for example, one or more microprocessors, microcontrollers and the like, according to the design preferences.

The memory devices 403 may comprise volatile memory devices and non-volatile memory devices of various kinds, for example SRAM and/or DRAM memories for volatile memories and solid-state memories, magnetic disks and/or optical disks for non-volatile memories.

Finally, it is apparent that modifications and variations may be made to the described microelectromechanical device, without departing from the scope of the present invention, as defined in the attached claims.

In particular, it is understood that all the connection structures described may be used with microelectromechanical devices of any type, both of membrane type and other types, according to the design preferences.

The support structure may be of any suitable type in addition to those described. For example, the MEMS die may be joined directly to a portion of the package, without the interposition of the control die and any suitable part of the packaging may function as a support structure. Conversely, other components may be interposed between the MEMS die and the packaging or the control die (for example, another die).

## Claims

1. A microelectromechanical device comprising:
a support structure (3, 5; 103, 105; 203, 205);
a microelectromechanical system die (7; 107; 207) incorporating a microstructure (12; 112; 212);
a connection structure (13; 113; 213) between the microelectromechanical system die (7; 107; 207) and the support structure (3, 5; 103, 105; 203, 205);
wherein the connection structure (13; 113; 213) comprises a spacer structure (15; 115; 215), joined to the support structure (3, 5; 103, 105; 203, 205), and a film (16; 116; 216) applied to a face of the spacer structure (15; 115; 215) opposite to the support structure (3, 5; 103, 105; 203, 205);
wherein the spacer structure (15; 115; 215) laterally delimits at least in part a cavity (18; 118; 218) and the film (16; 116; 216) extends on the cavity (18; 118; 218), at a distance from the support structure (3, 5; 103, 105; 203, 205) ;
and wherein the microelectromechanical system die (7; 107; 207) is joined to the film (16; 116; 216) on the cavity (18; 118; 218).

2. The device according to claim 1, wherein the film (16; 116; 216) is of dry resist.

3. The device according to claim 1 or 2, wherein the microelectromechanical system die (7; 107; 207) extends on the cavity (18; 118; 218) without overlapping the spacer structure (15; 115; 215) around the cavity (18; 118; 218).

4. The device according to any of the preceding claims, wherein the film (16; 116) defines a platform (21; 121) extending on the cavity (18; 118) and the microelectromechanical system die (7; 107) is joined to the platform (21; 121).

5. The device according to claim 4, wherein the cavity (18; 118) is filled with a sealing gel (25; 125).

6. The device according to any of the preceding claims, the platform (21; 121) is maintained suspended by an anchor (20; 120) .

7. The device according to claim 6, wherein the anchor (20; 120) is defined by an anchor portion (20; 120) of the spacer structure (15; 115).

8. The device according to claim 6 or 7, wherein the platform (21) is centrally supported by the anchor (20).

9. The device according to any of claims 6 to 8, wherein the platform (21) comprises a central anchor portion (21a) supported by the anchor (20), an outer frame (21b) and arms (21c) projecting from the anchor (20; 120) and connecting the central anchor portion (21a) to the outer frame (21b).

10. The device according to claim 6, wherein the platform (121) is supported laterally by the anchor (120).

11. The device according to claim 6 or 10, wherein the film (116) comprises an anchor portion (116a) supported by the anchor (120) and at least one arm (116b) connecting the anchor portion (116a) to the platform (121).

12. The device according to claim 11, wherein the platform (121) is frame-shaped and wherein an outer side of the platform (121) is connected to the anchor portion (116a) of the film (116) by the at least one arm (116b).

13. The device according to any of the preceding claims, wherein the support structure (3, 5; 103, 105; 203, 205) comprises a substrate (3; 103; 203) and a control die (5; 105; 205), joined to the substrate and functionally coupled to the microstructure (12; 112; 212) of the microelectromechanical system die (7; 107; 207) and wherein the connection structure (13; 113; 213) joins the microelectromechanical system die (7; 107; 207) to the control die (5; 105; 205).

14. An electronic system comprising a processing unit (402) and a microelectromechanical device (1) according to any of the preceding claims.

15. The system according to claim 14, wherein the microelectromechanical device (1) is a membrane device, in particular one of a pressure sensor and an electroacoustic transducer.

16. A process for manufacturing a microelectromechanical device, comprising:
depositing a spacer layer (301) of resist on a semiconductor wafer (300);
from the spacer layer (301), forming a spacer structure (15) laterally delimiting at least in part a cavity (18);
applying a film (16) to the semiconductor wafer (300), so that it adheres to the spacer structure (15);
joining a microelectromechanical system die (7) incorporating a microelectromechanical structure to the film (16) on the cavity (18).

17. The process according to claim 16, wherein the film (16) is of dry resist and is defined with a photolithographic process before joining the microelectromechanical system die (7) .
